# EUROPÄISCHE PATENTSCHRIFT

(11) **EP 1 206 038 B1**
(45) Veröffentlichungstag und Bekanntmachung des Hinweises auf die Patenterteilung: **17.09.2003**
(21) Anmeldenummer: 01123891.2
(22) Anmeldetag: 05.10.2001
(51) Int. Cl.: H03K 19/003, G11C 5/14, G11C 7/10

(54) **Schaltungsanordnung mit interner Versorgungsspannung**
Circuit arrangement with internal supply voltage
Circuit à tension d'alimentation interne

(30) Priorität: 08.11.2000 DE 10055242
(43) Veröffentlichungstag der Anmeldung: 15.05.2002
(73) Patentinhaber: Infineon Technologies AG, 81669 München (DE)
(72) Erfinder: Polney, Jens, 81539 München (DE)
(74) Vertreter: Epping Hermann & Fischer

(56) Entgegenhaltungen:
- EP-A- 0 469 588
- DE-A- 19 829 287
- US-A- 5 870 346
- US-A- 5 982 705

## Beschreibung

Die Erfindung betrifft eine Schaltungsanordnung mit intern erzeugter Versorgungsspannung, die aus einer extern angelegten Versorgungsspannung abgeleitet ist und Strompfade ansteuert.

In modernen integrierten Schaltungen werden Schaltstufen intern mit niedrigeren Versorgungsspannungen versorgt, als extern angelegt werden. Dadurch können die Transistoren für niedrigere Versorgungsspannung und damit kleiner dimensioniert werden. Die interne Versorgungsspannung wird durch einen Spannungsgenerator auf dem Chip der integrierten Schaltung erzeugt, welcher von der externen Versorgungsspannung versorgt wird. Solche Versorgungsspannungskonzepte finden insbesondere bei DRAMs Anwendung. Dort beträgt derzeit die externe Versorgungsspannung beispielsweise 2,5 V, die interne Versorgungsspannung liegt bei 2,0 V.

Schaltstufen in der integrierten Schaltung, die von der internen Versorgungsspannung versorgt werden, können als sogenannte dynamische Logik ausgeführt sein. Solche Schaltstufen umfassen einen Strompfad aus zwei Transistoren gleichen Kanaltyps, beispielsweise n-Kanal-MOS-Transistoren, deren Drain-Source-Strecken in Reihe zwischen den Anschluß für die interne Versorgungsspannung und Bezugspotential (Masse) geschaltet sind. Einer der Transistoren wird von einem Vorladesignal angesteuert, welches den Ausgang der Schaltstufe auf das Versorgungspotential auflädt. Im nachfolgenden Betriebstakt wird ein den zu übertragenden Logikzustand angebendes Logiksignal an den anderen der Transistoren des Strompfads angelegt, welches dann den Ausgang auf Versorgungspotential beläßt oder auf Masse zieht.

Die das Vorladesignal und das Logiksignal erzeugenden Schaltungen werden ebenfalls von der internen Versorgungsspannung gespeist. Beim Hochfahren des die interne Versorgungsspannung erzeugenden Spannungsgenerators besteht das Problem, daß die Logikpegel für das Vorlade- oder Logiksignal nicht definiert sind und sich zufällig einstellen. So kann der Fall auftreten, daß beide Transistoren des Strompfads der dynamischen Schaltstufe vollständig oder teilweise leitend gesteuert sind. Dann besteht ein leitender Strompfad zwischen dem Anschluß für die interne Versorgungsspannung und Bezugspotential. Der Spannungsgenerator für die interne Versorgungsspannung wird dadurch überlastet und kann ausfallen, so daß der Betriebspegel für die interne Versorgungsspannung nicht erreicht wird. Unter Umständen kann der Spannungsgenerator zerstört werden. Der Spannungsgenerator müßte dann für ausreichend hohe Betriebsströme dimensioniert werden, also größer als im Normalbetrieb eigentlich erforderlich ist. Dies hat einen unverhältnismäßig hohen Platzbedarf in der integrierten Schaltung zur Folge.

In der DE 198 29 287 ist ein synchroner dynamischer Halbleiterspeicher gezeigt, der eine den Einschaltvorgang steuernde Initialisierungsschaltung aufweist. Nach erfolgter Stabilisierung der Versorgungsspannung und Abarbeitung einer Initialisierungsabfolge ist der SDRAM für den ordnungsgemäßen Betrieb vorbereitet. Während des Einschaltvorgangs ist dafür zu sorgen, daß die internen, für den ordnungsgemäßen Betrieb vorgesehenen Steuerschaltungen sicher in einem definierten Sollzustand gehalten werden. Eine unerwünschte Aktivierung von Ausgangstransistoren, die auf den Datenleitungen einen Kurzschluß oder eine unkontrollierte Aktivierung von internen Stromverbrauchern hervorrufen könnte, wird dadurch verhindert.

Die Aufgabe der Erfindung besteht darin, eine Schaltungsanordnung mit intern erzeugter Versorgungsspannung anzugeben, die bei geringem Flächenverbrauch bei integrierter Herstellung betriebssicherer arbeitet.

Gemäß der Erfindung wird diese Aufgabe durch eine Schaltungsanordnung mit intern erzeugter Versorgungsspannung gelöst, umfassend: einen Anschluß zum Anlegen einer externen Versorgungsspannung; einen von der Versorgungsspannung gespeisten Spannungsgenerator mit einem Anschluß zum Abgriff der internen Versorgungsspannung, die von der externen Versorgungsspannung abweicht; einen Bezugspotentialanschluß; eine Schaltstufe, die von der internen Versorgungsspannung versorgt wird und mindestens zwei mit ihren gesteuerten Strompfaden in Reihe geschaltete Transistoren gleichen Leitungstyps umfaßt, von denen einer von einem Logiksteuersignal, der andere von einem Vorladesignal steuerbar ist; einer Steuerschaltung zur Erzeugung des Vorladesignals, die umfaßt: einen ersten Inverter, der signalseitig von einem weiteren Vorladesignal steuerbar ist, und versorgungsspannungsseitig über einen ersten und einen zweiten Transistor komplementären Leitungstyps an den Anschluß für die interne Versorgungsspannung und den Bezugspotentialanschluß angeschlossen ist, wobei die ersten und zweiten Transistoren komplementär von einem den Zustand ausreichender interner Versorgungsspannung anzeigenden Steuersignal ansteuerbar sind; einen zweiten Inverter, der eingangsseitig mit einem Ausgang des ersten Inverters verbunden ist und ausgangsseitig einen Anschluß zur Bereitstellung des Vorladesignals aufweist.

Bei der Schaltungsanordnung gemäß der Erfindung werden Schaltungsknoten der von der internen Versorgungsspannung versorgten Schaltstufen initialisiert. Dies bedeutet, daß bei Vorliegen von für den korrekten Betrieb noch nicht ausreichend hoher interner Versorgungsspannung die kritischen Schaltungsknoten so angesteuert werden, daß ein leitender zwischen die interne Versorgungsspannung und Bezugspotential liegender Strompfad sicher vermieden wird. Die Steuerungsschaltung sorgt dafür, daß das Vorladesignal während dieser Initialisierungsphase stets einen solchen Logikpegel aufweist, daß der Vorladetransistor sicher gesperrt ist. Bei n-Kanal-MOS-Vorladetransistoren hat das Vorladesignal während der Initialisierungsphase stets einen Low-Pegel. Erst nach Bereitstehen einer ausreichend hohen internen Versorgungsspannung wird das Vorladesignal freigegeben und ist entsprechend der gewünschten Signalverarbeitung taktweise steuerbar.

Der ausgangsseitige Inverter der Steuerschaltung kann vorteilhafterweise durch einen dritten Transistor während der Initialisierungsphase auf die externe Versorgungsspannung geklemmt werden. Dadurch wird sichergestellt, daß der Ausgang dieses Inverters sicher einen solchen Pegel einnimmt, daß der Vorladetransistor der Schaltstufe abgeschaltet ist. Dieser Inverter wird zweckmäßigerweise von der internen Versorgungsspannung angesteuert, so daß nur möglichst wenige Funktionselemente von der externen Versorgungsspannung versorgt werden.

Das eingangsseitig bereitgestellte Vorladesignal wird durch den ersten Inverter und diesen Inverter versorgungsspannungsseitig an die interne Versorgungsspannung bzw. Bezugspotential anlegenden ersten und zweiten Transistoren blockiert, so lange, bis ausreichend hohe interne Versorgungsspannung bereitsteht. Dieser Zustand wird durch ein entsprechendes Steuersignal angezeigt. Dieses Steuersignal wird komplementär an die den ersten Inverter an die interne Versorgungsspannung bzw. Bezugspotential anschließenden Transistoren angelegt. Dem einen dieser Transistoren wird dieses Steuersignal nicht invertiert, direkt zugeführt; dem anderen der Transistoren wird das Steuersignal über einen Inverter invertiert zugeführt. Dieser Inverter ist zweckmäßigerweise von der externen Versorgungsspannung mit Betriebsspannung zu versorgen.

Die Erfindung ist besonders dann vorteilhaft, wenn die zu initialisierende Schaltstufe in einem Ausgangstreiber der Schaltung angeordnet ist. Der Ausgangsanschluß dieses Ausgangstreibers ist dann mit einer Anschlußfläche, sogenanntes Pad, verbunden. Dies ist eine relativ große Metallisierungsfläche, auf der ein Bonddraht aufgestempelt wird, der mit einem Anschlußstift eines Gehäuses verbunden ist. Der Ausgangstreiber hat relativ groß dimensionierte Transistoren mit hoher Stromtreiberfähigkeit, so daß an den Anschlußstift des Gehäuses angeschlossene externe Leitungen, beispielsweise auf einer Schaltungsplatine verlaufend, getrieben werden können. Wenn ein solcher Strompfad in unzulässiger Weise beim Hochfahren des die interne Versorgungsspannung bereitstellenden Spannungsgenerators eine leitende Verbindung zwischen der internen Versorgungsspannung und Bezugspotential bilden würde, könnte ein relativ hoher Querstrom fließen. Durch die Erfindung wird bei einem Ausgangstreiber ein solcher unzulässiger Zustand durch die oben beschriebene Initialisierung vermieden.

Dasjenige Steuersignal, welches eine ausreichend hohe interne Versorgungsspannung anzeigt, kann ein Logiksignal sein, welches die intern erzeugte Versorgungsspannung mit einem Schwellwert vergleicht. Alternativ kann dieses Steuersignal direkt durch Pegelwandlung aus der intern erzeugten Versorgungsspannung abgeleitet werden. Der Pegelwandler wird von der externen versorgungsspannung versorgt und setzt den momentan vorliegenden Pegel der internen Versorgungsspannung auf einen auf die externe Versorgungsspannung referenzierten Logikpegel um.

Nachfolgend wird die Erfindung anhand des in der Zeichnung dargestellten Ausführungsbeispiels näher erläutert. Es zeigen:
- Figur 1: eine Schaltungsanordnung gemäß der Erfindung,
- Figur 2: ein Signaldiagramm von in der Schaltung gemäß Figur 1 auftretenden Spannungen und Signalen,
- Figur 3: ein Logiksignaldiagramm von in der Schaltung gemäß Figur 1 vorkommenden Signalen,
- Figur 4: eine Schaltungsanordnung gemäß der Erfindung speziell für einen Ausgangstreiber einer integrierten Schaltung und
- Figur 5: ein Logiksignaldiagramm für die Schaltung in Figur 4.

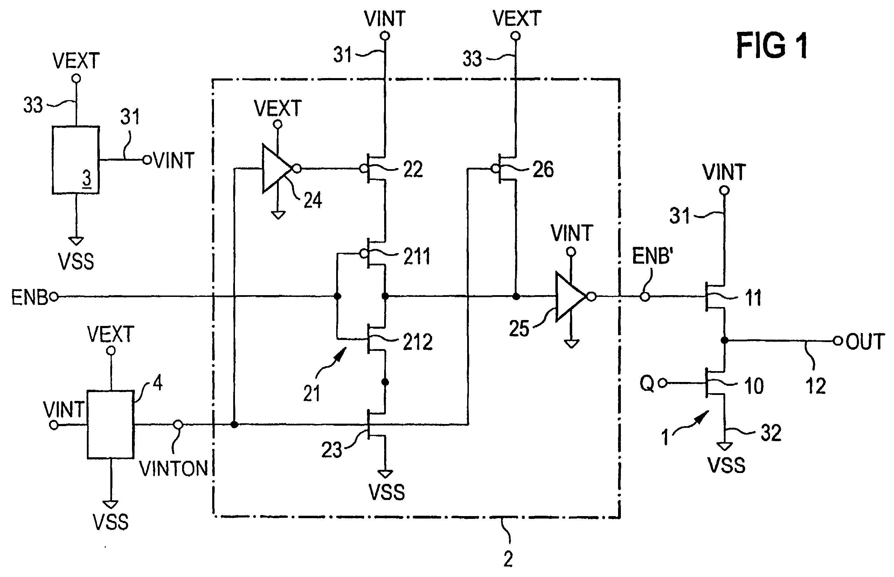

In Figur 1 ist mit 1 eine dynamische Schaltstufe gezeigt. Die Schaltstufe weist zwei mit ihren Drain-Source-Strecken in Reihe geschaltete n-Kanal-MOS-Transistoren 10, 11 auf. Diese Reihenschaltung ist zwischen Anschlüsse 31, 32 für eine von einem Spannungsgenerator erzeugte interne Versorgungsspannung geschaltet. Den negativen Pol der internen Versorgungsspannung bildet Bezugspotential VSS am Anschluß 32. Der positive Pol der internen Versorgungsspannung wird vom Versorgungspotential VINT am Anschluß 31 gebildet. Der Versorgungsspannungsgenerator 3 wird von einer extern bereitgestellten Versorgungsspannung VEXT gespeist und erzeugt durch geeignete bekannte Regelschaltungen das chipinterne Versorgungspotential VINT bzw. die entsprechende gegen Bezugspotential VSS gebildete interne Versorgungsspannung VINT. Die interne Versorgungsspannung VINT beträgt im Ausführungsbeispiel 2,0 V. Der Transistor 11 des dynamischen Ausgangstreibers 1 wird von einem Vorladesignal ENB' angesteuert. Ein High-Pegel des Signals ENB' steuert den Transistor 11 leitend, so daß der Ausgang 12 der dynamischen Schaltstufe 1 auf das interne Versorgungspotential VINT - Vthn vorgeladen wird. Dabei ist Vthn die Einsatzspannung des n-Kanal-Transistors 11. Im nächsten Betriebstakt wird das Vorladesignal ENB' wieder abgeschaltet, so daß der Pegel des Ausgangssignals OUT am Anschluß 12 durch das Logiksignal Q, welches den Transistor 10 ansteuert, eingestellt wird. Ein Low-Pegel des Signals Q sperrt den Transistor 10, so daß für das Ausgangssignal OUT weiterhin ein High-Pegel anliegt. Ein High-Pegel des Signals Q schaltet den Transistor 10 leitend, so daß der Ausgang 12 auf Bezugspotential VSS gezogen wird.

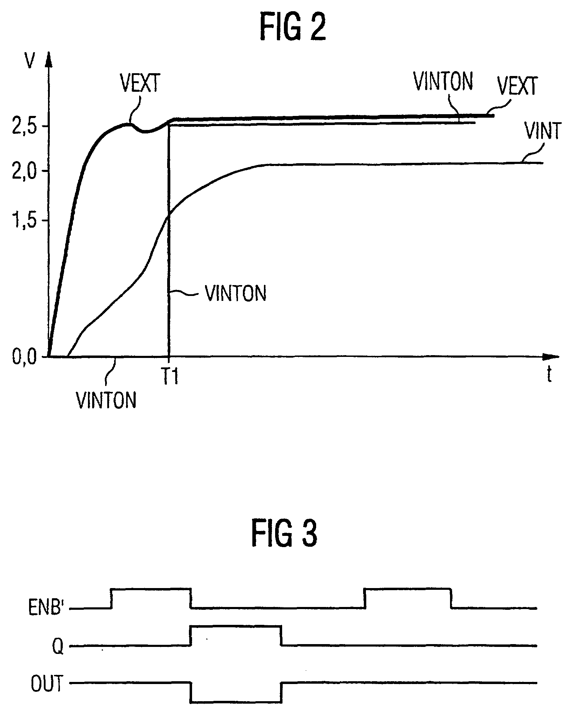

Solange die interne Versorgungsspannung VINT noch nicht ihren betriebssicheren ausreichend hohen Dauerbetriebspegel erreicht hat, könnten ohne die erfindungsgemäße Schaltungsanordnung die Transistoren 11, 10 beide gleichzeitig leitend gesteuert sein. Dann würde zwischen den Anschlüssen 31, 32 für die interne Versorgungsspannung ein leitender Strompfad vorliegen, welcher den Spannungsgenerator 3 übermäßig belastet. Um solche Schaltzustände während der Power-up-Phase für die interne Versorgungsspannung VINT zu vermeiden, dient die Steuerschaltung 2. Eingangsseitig wird der Steuerschaltung 2 ein von vorgeschalteten Schaltstufen erzeugtes Vorladesignal ENB zugeführt und außerdem ein Steuersignal VINTON, welches angibt, daß der Spannungsgenerator 3 eine betriebsbereite Ausgangsspannung hat. Wie in Figur 2 dargestellt, weist die externe Versorgungsspannung VEXT einen Pegel von 2,5 V auf. Die interne Versorgungsspannung VINT wird erst nach Bereitstehen einer ausreichend hohen externen Versorgungsspannung VEXT durch den Spannungsgenerator 3 erzeugt. Sie steigt relativ langsam an. Bei Erreichen einer ausreichend hohen internen Versorgungsspannung VINT, beispielsweise 1,5 V in Figur 2, wird das Signal VINTON aktiviert.

Die Steuerschaltung 2 weist einen Inverter 21 auf, dessen Signaleingang, d.h. die miteinander verbundenen Gate-Anschlüsse der Transistoren 211, 212, vom eingangsseitigen Vorladesignal ENB angesteuert wird. Die Versorgungsspannungsanschlüsse des Inverters 21 sind über einen p-Kanal-MOS-Transistor 22 mit der internen Versorgungsspannung VINT verbunden und außerdem über einen n-Kanal-MOS-Transistor 23 mit dem Anschluß für Bezugspotential VSS. Der aus den Transistoren 22, 211, 212, 23 gebildete Strompfad ist also an die interne Versorgungsspannung VINT angeschlossen. Der Transistor 23 wird direkt vom Steuersignal VINTON angesteuert. Der Transistor 22 wird dazu komplementär angesteuert. Ein Inverter 24 invertiert das Signal VINTON und ist ausgangsseitig mit dem Gate-Anschluß des Transistors 22 verbunden. Der Inverter 24 wird von der externen Versorgungsspannung VEXT versorgt.

Während der Initialisierungsphase vor dem Zeitpunkt T1 weist das Signal VINTON einen Low-Pegel auf. Die Transistoren 23, 22 sind dadurch gesperrt. Da der Inverter 24 von der externen Versorgungsspannung VEXT versorgt wird, liegt während der Initialisierungsphase der Ausgangspegel des Inverters 24 auf Höhe der externen Versorgungsspannung VEXT. Der p-Kanal-MOS-Transistor 22 ist dadurch sicher abgeschaltet. Während der Initialisierungsphase wird somit der Inverter 21 nicht mit Versorgungsspannung versorgt, so daß die Weiterleitung irgend eines Pegels des Signals ENB vermieden wird. Der Ausgang des Inverters 21 ist mit dem Eingang eines Inverters 25 verbunden, der ausgangsseitig das initialisierte Vorladesignal ENB' führt. Der Inverter 25 wird versorgungsspannungsseitig von der internen Versorgungsspannung VINT gespeist. Um sicherzustellen, daß während der Initialisierungsphase vor dem Zeitpunkt T1 das ausgangsseitige Vorladesignal ENB' einen Low-Pegel aufweist, ist der Eingang des Inverters 25 über einen p-Kanal-MOS-Transistor 26 an den Anschluß 33 für das externe Versorgungspotential VEXT geklemmt. Der Gate-Anschluß des Transistors 26 wird direkt vom Signal VINTON angesteuert, so daß der Transistor 26 während der Initialisierungsphase leitend ist und den Eingang des Inverters 25 auf den von der externen Versorgungsspannung VEXT gebildeten High-Pegel hält.

Wenn die interne Versorgungsspannung VINT einen Pegelwert von 1,5 V erreicht, wird das Signal VINTON von einem Low-Pegel auf einen High-Pegel umgeschaltet (Figur 2). Die Transistoren 22, 23 werden dadurch leitend geschaltet. Die Versorgungsspannungsanschlüsse des Transistors 21 werden an die interne Versorgungsspannung VINT bzw. Masse VSS gelegt. Darüber hinaus wird der Transistor 26 abgeschaltet. Folglich wird eine eingangsseitig anliegende Pegeländerung des Vorladesignals ENB an den Ausgang des Inverters 25 als Signal ENB' weitergeleitet. Die Steuerschaltung 2 ist dann transparent.

Das Signal VINTON kann durch Vergleich der vom Generator 3 erzeugten Spannung VINT mit dem Schwellwert von 1,5 V erzeugt werden. Alternativ ist es möglich, einen Pegelumsetzer 4 vorzusehen, dem direkt die interne Versorgungsspannung VINT zuführbar ist und welcher von der externen Versorgungsspannung VEXT versorgt wird. Der Pegelumsetzer 4 hat Schaltcharakteristik, so daß mit Überschreiten der Schwelle von 1,5 V durch die interne Versorgungsspannung VINT ausgangsseitig das Steuersignal VINTON mit Logikpegeln in Höhe der externen Versorgungsspannung VEXT erzeugt wird.

Die dargestellten n-Kanal-MOS-Transistoren und p-Kanal-MOS-Transistoren haben n- bzw. p-Leitungstyp. Die gesteuerten Strecken dieser Transistoren sind deren jeweilige Drain-Source-Pfade. Die Steueranschlüsse der Transistoren sind ihre Gate-Anschlüsse.

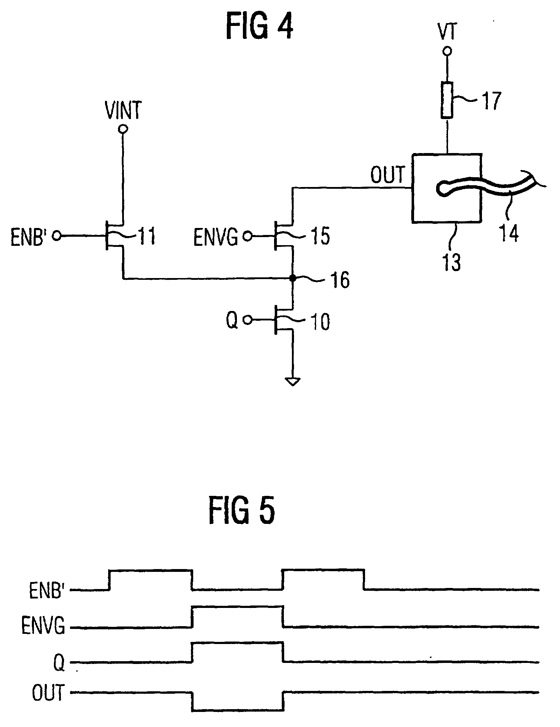

In Figur 4 ist der Ausgang 12 direkt mit einer Anschlußfläche 13 verbunden, sogenanntes Pad. Am Anschlußpad 13 wird ein Bonddraht 14 aufgestempelt, der den Schaltungsausgang an ein Gehäusepin führt. Das Gehäusepin ist mit Leitungen auf einer Schaltungsplatine verbunden. Um die Flankensteilheit der als Ausgangstreiber dienenden Schaltstufe 1 auf einen vorgegebenen Wert einstellen zu können, ist zusätzlich ein n-Kanal-MOS-Transistor 15 vorgesehen. Die Drain-Source-Strecke des Transistors 15 ist einerseits an den Kopplungsknoten 16 der Transistoren 10, 11 und andererseits an das Anschlußpad 13 angeschlossen. Das Pad 13 ist über einen Pull-up-Widerstand 17 mit einem Versorgungspotential VT verbunden. Der Transistor 11 dient zum Vorladen des Knotens 16 auf VINT - Vthn. Dadurch wird erreicht, daß beim Ausgeben eines High-Pegels über das Pad 13 kein kapazitiver Ausgleichsstrom in den Konten 16 fließt. Der Transistor 15 wird von einem Steuersignal ENVG angesteuert. Durch den Transistor 15 wird die Flankensteilheit einer Schaltflanke des auszugebenden, durch das Signal Q festgelegten Signalpegels, eingestellt.

## Patentansprüche

1. Schaltungsanordnung mit intern erzeugter Versorgungsspannung (VINT), umfassend:
- einen Anschluß (33) zum Anlegen einer externen Versorgungsspannung (VEXT);
- einen von der Versorgungsspannung (VEXT) gespeisten Spannungsgenerator (3) mit einem Anschluß (31) zum Abgriff der internen Versorgungsspannung (VINT), die von der externen Versorgungsspannung abweicht;
- einen Bezugspotentialanschluß (32, VSS);
- eine Schaltstufe (1), die von der internen Versorgungsspannung (VINT) versorgt wird und mindestens zwei mit ihren gesteuerten Strompfaden in Reihe geschaltete Transistoren (10, 11) gleichen Leitungstyps umfaßt, von denen einer von einem Logiksteuersignal (Q), der andere von einem Vorladesignal (ENB') steuerbar ist;
- einer Steuerschaltung (2) zur Erzeugung des Vorladesignals (ENB'), die umfaßt:
- einen ersten Inverter (21), der signalseitig von einem weiteren Vorladesignal (ENB) steuerbar ist und versorgungsspannungsseitig über einen ersten und einen zweiten Transistor (22, 23) komplementären Leitungstyps an den Anschluß für die interne Versorgungsspannung (31, VINT) und den Bezugspotentialanschluß (32, VSS) angeschlossen ist, wobei die ersten und zweiten Transistoren (22, 23) komplementär von einem den Zustand ausreichender interner Versorgungsspannung (VINT) anzeigenden Steuersignal (VINTON) ansteuerbar sind;
- einen zweiten Inverter (25), der eingangsseitig mit einem Ausgang des ersten Inverters (21) verbunden ist und ausgangsseitig einen Anschluß zur Bereitstellung des Vorladesignals (ENB') aufweist.

2. Schaltungsanordnung nach Anspruch 1,
**gekennzeichnet durch**
einen dritten Transistor (26), dessen gesteuerte Strecke an den Eingang des zweiten Inverters (25) und den Anschluß für die externe Versorgungsspannung (33, VEXT) angeschlossen ist und der von dem den Zustand ausreichender interner Versorgungsspannung (VINT) anzeigenden Steuersignal (VINTON) ansteuerbar ist.

3. Schaltungsanordnung nach Anspruch 1 oder 2,
**dadurch gekennzeichnet,**
**daß** der zweite Inverter (25) an den Anschluß (31) für die interne Versorgungsspannung (VINT) angeschlossen ist.

4. Schaltungsanordnung nach einem der Ansprüche 1 bis 3,
**dadurch gekennzeichnet,**
**daß** das den Zustand ausreichender interner Versorgungsspannung (VINT) anzeigende Steuersignal (VINTON) an einen Steueranschluß eines der ersten und zweiten Transistoren (23) nicht invertiert und an einen Steueranschluß eines anderen der ersten und zweiten Transistoren (22) über einen dritten Inverter (24) invertiert anlegbar ist und daß der dritte Inverter (24) an den Anschluß (33) für die externe Versorgungsspannung (VEXT) angeschlossen ist.

5. Schaltungsanordnung nach einem der Ansprüche 1 bis 4,
**dadurch gekennzeichnet,**
**daß** die Schaltstufe (1) einen Ausgangstreiber einer integrierten Schaltung bildet und ausgangsseitig mit einer Anschlußfläche (13) verbunden ist, an der ein Signal von der integrierten Schaltung von extern abgreifbar ist.

6. Schaltungsanordnung nach Anspruch 5,
**gekennzeichnet durch**
einen weiteren Transistor (15), über dessen gesteuerte Strekke der Kopplungsknoten (16) der Transistoren (10, 11) der Schaltstufe (1) mit der Anschlußfläche (13) verbunden ist und der von einem weiteren Steuersignal (ENVG) steuerbar ist.

7. Schaltungsanordnung nach einem der Ansprüche 1 bis 6,
**dadurch gekennzeichnet,**
**daß** die interne Versorgungsspannung (VINT) bezogen auf Bezugspotential (VSS) betragsmäßig kleiner ist als die externe Versorgungsspannung (VEXT).

8. Schaltungsanordnung nach einem der Ansprüche 1 bis 7,
**dadurch gekennzeichnet,**
**daß** das den Zustand ausreichender interner Versorgungsspannung (VINT) anzeigende Steuersignal (VINTON) am Ausgang eines Pegelumsetzers (4) abgreifbar ist, der mit dem Anschluß (33) für die externe Versorgungsspannung (VEXT) verbunden ist und der signaleingangsseitig von der internen Versorgungsspannung (VINT) ansteuerbar ist.

## Claims

1. Circuit arrangement with an internally generated supply voltage (VINT), comprising:
- a terminal (33) for applying an external supply voltage (VEXT);
- a voltage generator (3) fed by the supply voltage (VEXT) and having a terminal (31) for tapping off the internal supply voltage (VINT), which deviates from the external supply voltage;
- a reference potential terminal (32, VSS);
- a switching stage (1), which is supplied by the internal supply voltage (VINT) and comprises at least two transistors (10, 11) of the same conductivity type, which are connected in series by their controlled current paths and of which one can be controlled by a logic control signal (Q) and the other by a precharge signal (ENB');
- a control circuit (2) for generating the precharge signal (ENB'), which comprises:
- a first inverter (21) which, on the signal side, can be controlled by a further precharge signal (ENB) and, on the supply voltage side, is connected via a first and a second transistor (22, 23) of complementary conductivity types to the terminal for the internal supply voltage (31, VINT) and the reference potential terminal (32, VSS), in which the first and second transistors (22, 23) can be driven in a complementary manner by a control signal (VINTON) indicating the state of sufficient internal supply voltage (VINT);
- a second inverter (25) which, on the input side, is connected to an output of the first inverter (21) and, on the output side, has a terminal for providing the precharge signal (ENB').

2. Circuit arrangement according to Claim 1,
**characterized by**
a third transistor (26), whose controlled path is connected to the input of the second inverter (25) and the terminal for the external supply voltage (33, VEXT) and which can be driven by the control signal (VINTON) indicating the state of sufficient internal supply voltage (VINT).

3. Circuit arrangement according to Claim 1 or 2,
**characterized**
**in that** the second inverter (25) is connected to the terminal (31) for the internal supply voltage (VINT).

4. Circuit arrangement according to one of claims 1 to 3,
**characterized**
**in that** the control signal (VINTON) indicating the state of sufficient internal supply voltage (VINT) can be applied in non-inverted form to a control terminal of one of the first and second transistors (23) and in inverted form, via a third inverter (24), to a control terminal of another of the first and second transistors (22), and in that the third inverter (24) is connected to the terminal (33) for the external supply voltage (VEXT).

5. Circuit arrangement according to one of Claims 1 to 4,
**characterized**
**in that** the switching stage (1) forms an output driver of an integrated circuit and, on the output side, is connected to a pad (13), at which a signal can be tapped off from the integrated circuit externally.

6. Circuit arrangement according to Claim 5,
**characterized by**
a further transistor (15), via whose controlled path the coupling node (16) of the transistors (10, 11) of the switching stage (1) is connected to the pad (13) and which can be controlled by a further control signal (ENVG).

7. Circuit arrangement according to one of Claims 1 to 6,
**characterized**
**in that** the internal supply voltage (VINT), with reference to reference potential (VSS), has a smallermagnitude than the external supply voltage (VEXT).

8. Circuit arrangement according to one of Claims 1 to 7,
**characterized**
**in that** the control signal (VINTON) indicating the state of sufficient internal supply voltage (VINT) can be tapped off at the output of a level converter (4), which is connected to the terminal (33) for the external supply voltage (VEXT) and, on the signal input side, can be driven by the internal supply voltage (VINT).

## Revendications

1. Circuit à tension (VINT) d'alimentation produite de manière interne et comprenant :
- une borne (13) d'application d'une tension (VEXT) extérieure d'alimentation ;
- un générateur (3) de tension alimenté par la tension (VEXT) d'alimentation et ayant une borne (31) de prélèvement de la tension (VINT) interne d'alimentation qui est distincte de la tension extérieure d'alimentation ;
- une borne (32, VSS) de potentiel de référence ;
- un étage (1) de commutation, qui est alimenté par la tension (VINT) interne d'alimentation et qui a au moins deux transistors (10, 11) du même type de conductivité montés en série par leur voie de courant commandé, dont l'un peut être commandé par un signal (Q) logique de commande, tandis que l'autre peut être commandé par un signal (ENB') de précharge ;
- un circuit (2) de commande de production du signal (ENB') de précharge, qui comprend :
- un premier inverseur (21), qui est commandé du côté du signal par un autre signal (ENB) de précharge et qui est relié du côté de la tension de l'alimentation par l'intermédiaire d'un premier et d'un deuxième transistor (22, 23) de type de conductivité complémentaire à la borne pour la tension (31, VINT) interne d'alimentation et à la borne (32, VSS) de potentiel de référence, les premier et deuxième transistors (22, 23) pouvant être commandés complémentairement d'un signal (VINTON) de commande indiquant l'état d'une tension (VINT) interne d'alimentation suffisante ;
- un deuxième inverseur (25), qui est relié du côté de l'entrée à une sortie du premier inverseur (21) et qui a, du côté de la sortie, une borne de mise à disposition du signal (ENB') de précharge.

2. Circuit suivant la revendication 1,
**caractérisé**
**par** un troisième transistor (26), dont la section commandée est reliée à l'entrée du deuxième inverseur (25) et à la borne pour la tension (33, VEXT) externe d'alimentation et qui peut être commandée par le signal (VINTON) de commande indiquant l'état suffisant de la tension (VINT) interne d'alimentation.

3. Circuit suivant la revendication 1 ou 2,
**caractérisé**
**en ce que** le deuxième inverseur (25) est relié à la borne (31) pour la tension (VINT) interne d'alimentation.

4. Circuit suivant l'une des revendications 1 à 3,
**caractérisé**
**en ce que** le signal (VINTON) de commande indiquant l'état de tension (VINT) suffisante interne d'alimentation est appliqué sans être inversé sur l'une des bornes de commande de l'un des premier et deuxième transistors (23) et est appliqué inversé sur une borne de commande d'un autre des premier et deuxième transistors (22) par l'intermédiaire d'un troisième inverseur (24) et en ce que le troisième inverseur (24) est relié à la borne (33) pour la tension (VEXT) extérieure d'alimentation.

5. Circuit suivant l'une des revendications 1 à 4,
**caractérisé**
**en ce que** l'étage (1) de commutation forme un étage de sortie d'un circuit intégré et est relié du côté de la sortie à une surface (13) formant borne sur laquelle un signal peut être prélevé de l'extérieur par le circuit intégré.

6. Circuit suivant la revendication 5,
**caractérisé**
**par** un autre transistor (15) par la section commandée duquel le noeud (16) de couplage des transistors (10, 11) de l'étage (1) de commutation est relié à la surface (13) formant borne et peut être commandé par un autre signal (ENVG) de commande.

7. Circuit suivant l'une des revendications 1 à 6,
**caractérisé**
**en ce que** la tension (VINT) interne d'alimentation est, rapportée au potentiel (VSS) de référence, plus petite en valeur absolue que la tension (VEXT) externe d'alimentation.

8. Circuit suivant l'une des revendications 1 à 7,
**caractérisé**
**en ce que** le signal (VINTON) de commande indiquant l'état de tension (VINT) suffisante interne d'alimentation peut être prélevé à la sortie d'un convertisseur (4) de niveau qui est relié à la borne (33) pour la tension (VEXT) externe d'alimentation et qui peut être commandé du côté de l'entrée du signal par la tension (VINT) interne d'alimentation.
